(19) Europäisches Patentamt
European Patent Office
Office européen des brevets

(11) **EP 1 365 506 B1**

(12) **EUROPEAN PATENT SPECIFICATION**

(45) Date of publication and mention
of the grant of the patent:
**14.11.2007 Bulletin 2007/46**

(51) Int Cl.:
**_H03G 3/30_** _(2006.01)_

(21) Application number: **02425322.1**

(22) Date of filing: **22.05.2002**

(54) **Up-converter for radio systems**

Aufwärtsfrequenzwandler für Radiosysteme

Convertisseur éleveur de fréquence pour système radio

(84) Designated Contracting States:
**AT BE CH CY DE DK ES FI FR GB GR IE IT LI LU MC NL PT SE TR**

(43) Date of publication of application:
**26.11.2003 Bulletin 2003/48**

(73) Proprietor: **Siemens S.p.A.**
**20126 Milano (IT)**

(72) Inventors:
• **Foltran, Gabriele**
**20092 Cinisello Balsamo (IT)**
• **Motta, Maurizio**
**20036 Meda (IT)**

• **Negri, Luigi**
**26866 S.Angelo Lodigiano (IT)**
• **Piloni, Marco**
**20090 Vimodrone (IT)**

(74) Representative: **Giustini, Delio**
**Siemens Information and
Communication Networks S.p.A.,
Palazzo Gorky
Via Monfalcone, 1
20092 Cinisello Balsamo (IT)**

(56) References cited:
**EP-A- 0 734 118**     **US-A- 6 104 246**
**US-A1- 2001 011 926**     **US-B1- 6 175 279**

**Description**

Field of the invention

The present invention refers to up-converters for radio systems and was developed by paying specific attention to the ever-increasing need for high performance up-converters for mmw (millimeter wave) radio systems.

More specifically the present invention relates to an up-converter circuit according to the preamble of claim 1, which is known, e.g. from US 2001/0053676

Recent developments in radio network standards (ETSI, FCCI, ...), particularly in respect of SDH (Synchronous Digital Hierarchy), BWA (Broadband Wireless Access) and PtMP (Point to MultiPoint) systems impose increasingly severe requirements in terms of output power spectrum masks. These include strict requirements in term of transmitted spectrum mask constrains and noise output power during switch off in burst mode operation.

In order to meet those requirements, microwave transmitters, and especially those operating in the mmw frequency bands (i.e. in frequency ranges leading to very critical operating conditions for circuitry) must exhibit good performance in terms of linearity (IP3 - $P_{1dB}$ - IMR3), output power dynamic range, dc power consumption and output noise power density.

Background art

The up-converter circuit of this kind are arranged in such way to include:

- an input stage for producing an IF signal to be frequency up-converted,
- a local oscillator for generating a local oscillator signal,
- a mixer stage fed with said IF signal and said local oscillator signal for generating an up-converted RF signal by mixing said IF signal and said local oscillator signal,
- a RF amplifier chain fed with said up-converted RF signal for amplifying said up-converted RF signal by a given gain value, wherein said amplifier chain includes a plurality of linear attenuation stages and means aiming at automatically controlling gain by keeping the compression power constant as output power level is varied.

The Application Note 1048 Hewlett Packard, printed in the U.S.A. 11/1997, shows a Pin diode based variable attenuator. This device provides good linearity but it is very difficult to implement as an integrated circuit (IC) at mmw (beyond 30 GHz), furthermore a discrete diodes design solution would result too much critical and complex in this frequency range. Conversely they can not used at IF stage because of NF requirements at IF input port.

The data sheet Agilent HMMC-1002 DC-50 Ghz Attenuator, printed on February 19, 2001 shows a Voltage Variable Attenuators (VVA) implemented in mmw IC form. They provide good dynamic range but suffer from linearity problems since Fet junctions (a no linear element) is used as variable resistors.

Object and summary of the Invention

The object of the present invention is to overcame some of the intrinsic drawbacks of those prior art arrangements, i.e. to provide an up-converter adapted for operation in the mmw frequency bands ensuring a good performance level while also exhibiting lower production cost (including assembly and tuning).

According to the present invention that object is achieved by means of an up-converter having the features called for in claim 1.

The claimed up converter permits degradation to be easily controlled having each amplifier stage of said plurality a respective, selectively controllable gain value, and at least one gain control module for varying said given gain value of said RF amplifier chain by uniformly varying the respective gains of said amplifier stages. The present architecture, does not require any additional variable attenuator device; in this way it is not necessary to insert further amplification stage (to compensate variable attenuator insertion loss), and dc power consumption is optimised according to the output power level setting.

Brief description of the drawings

The invention will now be described, by way of example only, with reference to the annexed figures of drawings, wherein:

- Figure 1 is a block diagram of an up-converter according to the invention,
- Figure 2 is a block diagram of a bias source adapted for use in the up-converter of the invention,

- Figure 3 is a diagram showing the gain v. drain current relationship in a FET amplifier stage adapted for use in the invention, and
- Figure 4 is a diagram showing the output power v. input power relationship in a converter according to the invention.

Detailed description of a preferred embodiment of the Invention

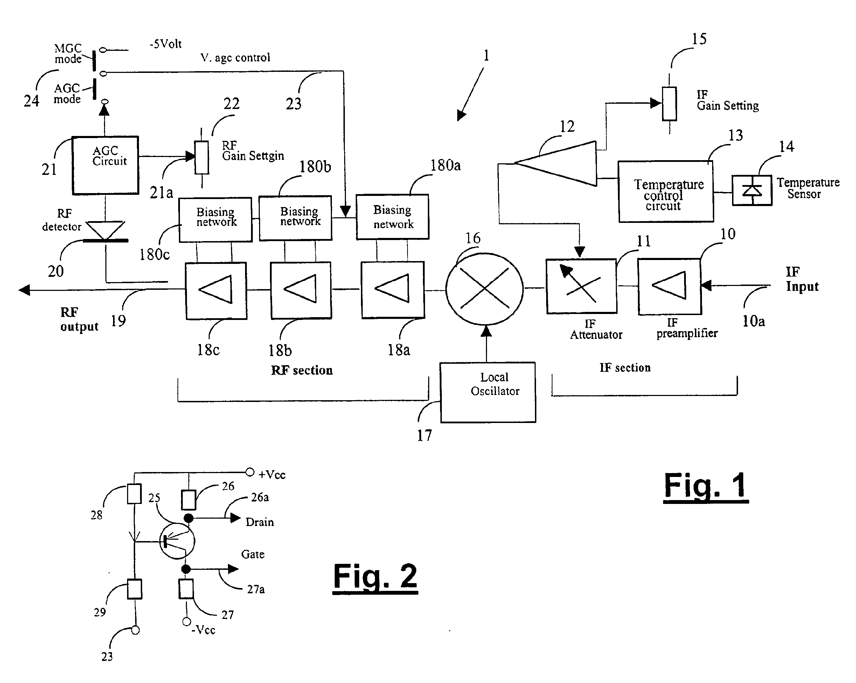

In figure 1 an up-converter adapted for operating e.g. in the 38 and 41 GHz frequency bands is designated 1 as a whole.

Of course, the indicated frequency bands are for exemplary purposes only and must in no way be construed as limiting the scope of the invention.

The input stage of up-converter 1 is essentially comprised of a low noise amplifier (LNA) stage operating in the intermediate frequency (IF) range. The IF stage in question includes an IF pre-amplifier 10 having an input line 10a for receiving an IF input signal to be frequency up-converted. Cascaded with pre-amplifier 10 is preferably an IF automatic gain control (AGC) block 11 having an input control line receiving a temperature control signal generated by a comparator 12.

A first input of comparator 12 is connected to a temperature control circuit 13 fed with a temperature signal generated by a temperature sensor 14. The other input of comparator 12 is connected to an IF gain setting unit 15 essentially comprised of a potentiometer.

The arrangement made up of blocks 11 to 15 is conventional in the art and, as such, does not require to be described in greater detail here.

The output signal from the IF section comprised of pre-amplifier 10 and gain control block 11 is fed to mixer stage 16 which is preferably comprised of a LO-Image reject mixer fed with the signal generated by a local oscillator 17.

As a result of mixing in mixer 16, an RF signal is generated which substantially corresponds to the IF signal input on line 10a up-converted by a frequency value corresponding to the value of the frequency of the local signal generated by oscillator 17.

Reference numerals 18a, 18b and 18c designate a plurality of amplifier stages making up an RF amplifier chain adapted to generate on an output line 19 an RF output signal adapted to be fed e.g. to an antenna (not shown).

Even though three amplifier stages 18a, 18b, 18c are shown in figure 1, the number of amplifier stages comprising the RF amplifier chain may be different from three. Essentially, depending on the expected application, the number of such RF amplifier stages is selected as a judicious compromise between the overall gain value to be achieved and circuit complexity.

Each of amplifier stages 18a, 18b, 18c has associated therewith a biasing network 180a, 180b, 180c.

Reference 20 designates a radio frequency detector of a known type associated with output line 19 to detect the power level at the output of the RF amplifier chain including amplifier stages 18a, 18b and 18c. The output signal from power detector 20 is fed to an automatic gain control (AGC) circuit 21.

AGC circuit 21 is adapted to selectively vary the gain figure of the RF amplifier chain comprising stages 18a, 18b and 18c by acting or biasing networks 180a, 180b, 180c according to principles which will be described in greater detail in the following.

Specifically, circuit 21 is controlled through a line 21 a by a RF gain setting unit 22 of a known type.

The automatic gain control signal generated by circuit 21 is fed back over a line 23 towards the stages 18a, 18b, and 18c of the RF amplifier chain.

Specifically, line 23 is connected with one or more biasing networks 180a, 180b and 180c to selectively control the gain values of amplifier stages 18a, 18b and 18c as better described in the following.

Reference 24 designates a switch which permits the automatic gain control (AGC) feedback loop from circuit 21 represented by line 23 to be selectively interrupted in order to connect line 23 to a fixed voltage value (e.g. -5 volt) to permit manual gain control (MGC) during preliminary adjustment and trimming procedures and/or during testing.

It will be appreciated that block 11 and the circuitry associated therewith, comprised of elements 12 to 15, is intended to control gain of the IF section (10, 11) of the up-converter in order to compensate temperature drift phenomena.

Conversely, the AGC function proper is performed in the RF section by properly varying (via networks 180a, 180b and 180c) the operating conditions of amplifier stages 18a, 18b and 18c.

The arrangement shown in figure 1 does not involve any additional attenuator circuit in the RF section which represents an appreciable advantage over prior art arrangements including such circuits by taking into account that e.g. pin diode attenuators, while providing good linearity, are not easy to implement by resorting to MMIC devices in the millimeter wave operating range.

Conversely, in the arrangement shown, to reduce gain at the RF level a high level up-converter mixer 16 is used. In that way the input noise figure is improved by using a LNA IF stage.

In order to provide the desired output power dynamic range while preserving noise figure and IMR3 (linearity) performance, the overall gain of the amplifying chain comprised of stages 18a, 18b and 18c is selectively varied by correspondingly varying - in a uniform manner - the gain of each and every stage included therein.

This is preferably done by correspondingly varying the gain value for each stage in the chain in a uniform way by using variable bias current sources 180a, 180b, 180c preferably having the general structure shown in figure 2.

In order to properly operate the millimeter wave amplifying chain comprised of amplifier stages 18a, 18b and 18c the amplifying chain is thus dimensioned according to linearity criteria while making sure that the driver stages do not lead to an undesired compression of the signal in the following stages.

In a preferred embodiment of the invention, a current source as shown in figure 2 is preferably provided for each of the amplifier stages 18a, 18b and 18c of the RF amplifier chain shown in figure 1. Arrangements wherein one such current source is provided for driving two or more of the amplifier stages 18a, 18b, 18c are also within the scope of the present invention.

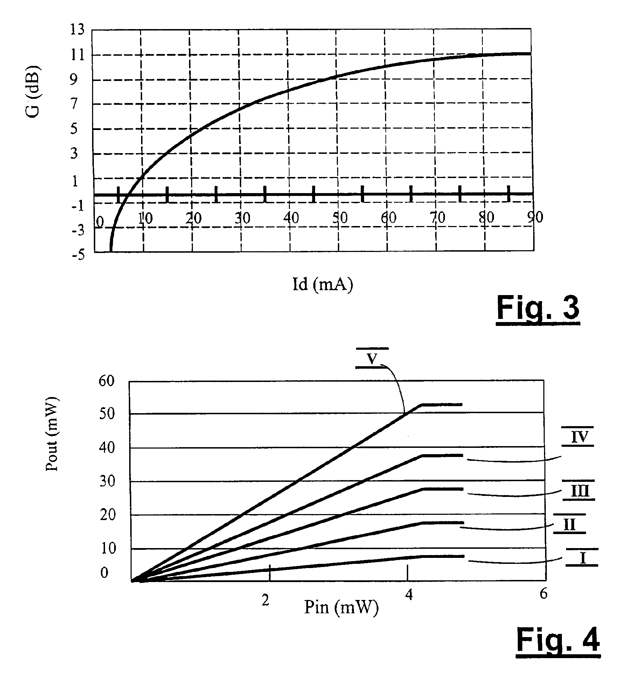

In order to understand operation of such a current source, reference may be had to figure 3 of the drawings showing the relationship between the drain current Id (mA - horizontal scale) and the gain (dB - vertical scale) in a typical FET amplifier stage.

The block diagram of figure 2 shows the typical arrangement of a current source adapted to be controlled via a control line: this is designated 23 for the sake of consistency with the block diagram of figure 1.

Assuming optimal matching conditions with the load and that the saturation region of a FET amplifier is ideal, the maximum output power $P_{max}$ (with no harmonic distortion) may be expressed as:

$$P_{max} = I_d \cdot V_d/8,$$

where $I_d$ and $V_d$ correspond to the drain current intensity and the drain voltage, respectively.

As a consequence of this, in order to vary the gain of the stages 18a, 18b and 18c in the RF chain by maintaining linearity thereof, both $I_d$ and $V_d$ may be controlled.

This can be obtained by means of the arrangement of figure 2 including a BJT transistor 25.

The emitter-collector line of transistor 25 is connected between a power feed line Vcc at and a (preferably negative) reference value - Vcc.

The emitter and collector of transistor 24 have associated respective resistor designated 26 and 27, respectively. Corresponding signals for driving the drain and gate electrodes of the FET amplifier(s) included in stages 18a, 18b, and 18c can thus be drawn from respective bias control lines at the emitter (line 26a) and the collector (line 27a) of transistor 25, respectively.

The base of transistor 25 is connected to the intermediate point of a voltage divider including two resistors 28 and 29 connected in series between the power feed voltage Vcc and the voltage control point connected to feedback line 23.

The diagram of figure 4 shows the output power (Pout - mW) versus input power (Pin - mW) of a FET amplifier stage for different values of drain current for drain current values ($I_d$) corresponding to 10 mA (I), 30 mA (II), 50 mA (III), 70 mA (IV) and 90 mA (V), respectively.

It will be appreciated that the arrangement of the invention overcomes the intrinsic drawbacks of those prior art arrangements aiming at automatically controlling gain by keeping the compression power constant as gain is varied. The arrangement disclosed permits degradation to be easily controlled since, as $I_d$ varies, the ratio between the "useful" signal and the intermodulation products is kept constant.

The gain control technique just described is particularly adapted to be carried out on a RF amplifier chain.

The choice of the component on which gain control is to be performed is in fact critical as it affects both the noise figure and the level of intermodulation products.

In a chain including n stages, if gain control is performed at one of the input stages of the chain, the noise figure is adversely affected. Conversely, if control is performed at one of the last stages in the chain, linearity is compromised. The arrangement of the invention provides for those parameters being controlled concurrently, in order to preserve the overall performance of the system while ensuring a reasonably high gain dynamics.

In the arrangement of the invention, in order to provide output power dynamic range while safeguarding performance in terms of the noise figure and linearity (IMR3) the gain of the whole RF amplifier chain (stages 18a, 18b, and 18c) is varied by simultaneously and uniformly varying the gain values of each and every stage in the chain.

In the case of FET amplifier stages, this is done preferably by controlling the values of the drain current Id of each stage. In order to operate properly, the whole chain is designed according to linearity criteria, ensuring that drivers should not compress subsequent stages.

In the arrangement of the invention, output power may be optimised versus dc power consumption. This is due to a lower current being needed for low output power levels.

Such a feature is particularly useful in systems using power control arrangements of the ATPC (Automatic Transmitter Power Control) or RTPC (Remote Transmitter Power Control) type during normal operation, e.g. at low power levels because of the lower dc power consumption. Operation temperature is also decreased, thus improving the transmitter MTBF.

In the presently preferred embodiment up-converter 11 is implemented by resorting to microstrip transmission line technology using MMIC devices and ceramic substrate hybrids.

Such an assembly is adapted for fully automated production using epoxy attach techniques. No manual tuning of converter 1 is required and output power calibration may be carried out by means of a fully automated software-controlled routine.

A summary of the most significant performance parameters of an exemplary embodiment of an up-converter according to the invention is provided in Table 1 that follows.

| Frequency range | $37 \div 39.5$ GHz<br>$40.5 \div 43.5$ GHz |
|---|---|
| Output power dynamic range | $1 \div 21$ dBm |
| IMR3 With reference to single channel level | $>= 40$ dBc @ any Pout |
| NF at input port | $\leq 15$ dB @ Pmax<br>$\leq 25$ dB @ Pmin |
| Dc power consumption | $\leq 12$ W @ Pmax<br>$\leq 7$ W @ Pmin |

The invention thus provides an improved up-converter arrangement adapted for operating in the mm-wave frequency bands for radio applications. The main features of such an arrangement are high linearity and dynamic range, adaptive dc power consumption and low noise figure.

Of course, without prejudice to the principle of the invention, the details of construction and the embodiments may widely vary with respect to what has been described and illustrated purely by way of example, without departing from the scope of the present invention.

**Claims**

1. An up-converter circuit (1) comprising:

   - an input stage (10, 11) for producing an IF signal to be frequency up-converted,
   - a local oscillator (17) for generating a local oscillator signal,
   - a mixer stage (16) fed with said IF signal and said local oscillator signal for generating an up-converted RF signal by mixing said IF signal and said local oscillator signal,
   - a RF amplifier chain (18a, 18b, 18c) fed with said up-converted RF signal for amplifying said up-converted RF signal by a given gain value,

   **characterised in that** said amplifier chain includes:

   a) a plurality of amplifier stages (18a, 18b, 18c), wherein each amplifier stage of said plurality have a respective, selectively controllable gain value,
   b) at least one gain control module (180a, 180b, 180c) is provided for varying said given gain value of said RF amplifier chain by uniformly varying the respective gains of said amplifier stages (18a, 18b, 18c) of said RF amplifier chain and

   said at least one gain control module (180a, 180b, 180c) has associated therewith a RF power detector (20) for sensing the power of said up-converted RF signal as amplified by said given gain value by said RF amplifier chain (18a, 18b, 18c) wherein said respective gains of the amplifier stages (18a, 18b, 18c) of said RF amplifier chain are selectively varied as a function of said power of said up-converted and amplified RF signal.

2. The circuit of claim 1 , **characterised in that** the amplifier stages (18a, 18b, 18c) of said RF amplifier chain are FET amplifier stages, wherein said respective gains of said amplifier stages (18a, 18b, 18c) are varied by varying at least one the drain current (Id) and the drain-source voltage (Vds) of the FET amplifier stage.

3. The circuit of claim 2, **characterised in that** said at least one gain control module (180a, 180b, 180c) includes:

   - a gain control input port (23) adapted to be brought to a given gain control voltage,
   - a transistor (25) having base, emitter and collector ports, and
   - a voltage divider (28, 29) sensitive to said given voltage at said gain control input port (23), said voltage divider having a tap point connected to the base port of said transistor (25), wherein said emitter and collector ports of said transistor (25) are connected to the drain and the gate ports, respectively, of at least one of said FET amplifier stages in said RF amplifier chain (18a, 18b, 18c).

4. The circuit of any of the previous claims, **characterised in that** said input stage (10, 11) includes at least one variable gain block (11) as well as temperature-sensitive control circuitry (12 to 15) for selectively varying the gain of said at least one block (11) as a function of temperature.

5. The circuit of any of the previous claims, **characterised in that** said RF amplifier chain (18a, 18b, 18c) is configured to operate in the tens of GHz range preferably in the 40 GHz range.

**Patentansprüche**

1. Aufwärtsfrequenzwandler-Schaltungsanordnung (1), welche Folgendes umfasst:

   - eine Eingangsstufe (10, 11) zum Erzeugen eines Zwischenfrequenz (ZF) -Signals, welches aufwärts gewandelt werden soll,
   - einen lokalen Oszillator (17) zum Erzeugen eines Lokaloszillator-Signals,
   - eine Mischerstufe (16), in die das besagte Zwischenfrequenz (ZF) -Signal und das besagte Lokaloszillator-Signal eingespeist werden, um ein aufwärts gewandeltes Hochfrequenz (HF) -Signal zu erzeugen, indem das besagte Zwischenfrequenz (ZF) -Signal und das besagte Lokaloszillatorsignal gemischt werden,
   - eine Hochfrequenz (HF) -Verstärkerkette (18a, 18b, 18c), in die das besagte aufwärts gewandelte Hochfrequenz (HF) -Signal eingespeist wird, um das besagte aufwärts gewandelte Hochfrequenz (HF) -Signal um einen vorgegebenen Verstärkungsfaktor zu verstärken,

   **dadurch gekennzeichnet, dass** die besagte Hochfrequenz (HF) -Verstärkerkette Folgendes beinhaltet:

   a) eine Mehrzahl von Verstärkerstufen (18a, 18b, 18c), wobei jede Verstärkerstufe der besagten Mehrzahl einen jeweiligen selektiv regelbaren Verstärkungsfaktor aufweist,
   b) mindestens ein Verstärkungsregelungs-Modul (180a, 180b, 180c) wird bereitgestellt, um den besagten vorgegebenen Verstärkungsfaktor der besagten Hochfrequenz (HF) -Verstärkerkette zu verändern, indem die jeweiligen Verstärkungsfaktoren der besagten Verstärkerstufen (18a, 18b, 18c) der besagten Hochfrequenz (HF) -Verstärkerkette gleichförmig verändert werden, und

   wobei das besagte mindestens eine Verstärkungsregelungs-Modul (180a, 180b, 180c) einen diesem zugeordneten Hochfrequenz (HF) -Leistungsdetektor (20) besitzt, um die Stärke des besagten aufwärts gewandelten Hochfrequenz (HF) -Signals zu erkennen, das um den besagten vorgegebenen Verstärkungsfaktor durch die besagte Hochfrequenz (HF) -Verstärkerkette (18a, 18b, 18c) verstärkt wurde, wobei die besagten jeweiligen Verstärkungsfaktoren der Verstärkerstufen (18a, 18b, 18c) der besagten Hochfrequenz (HF) -Verstärkerkette selektiv verändert werden in Abhängigkeit von der besagten Stärke des besagten aufwärts gewandelten und verstärkten Hochfrequenz (HF) -Signals.

2. Schaltungsanordnung gemäß Anspruch 1, **dadurch gekennzeichnet, dass** die Verstärkerstufen (18a, 18b, 18c) der besagten Hochfrequenz (HF) -Verstärkerkette Feldeffekttransistor (FET) -Verstärkerstufen sind, wobei die besagten jeweiligen Verstärkungsfaktoren der besagten Verstärkerstufen (18a, 18b, 18c) verändert werden, indem mindestens entweder der Drain-Strom (Id) oder die Drain-Source-Spannung (Vds) der Feldeffekttransistor (FET) -Verstärkerstufe verändert wird.

3. Schaltungsanordnung gemäß Anspruch 2, **dadurch gekennzeichnet, dass** das besagte mindestens eine Verstärkungsregelungs-Modul (180a, 180b, 180c) Folgendes umfasst:

   - einen Verstärkungsregelungs-Eingang (23), der dafür ausgelegt ist, auf eine vorgegebene Verstärkungsregelungs-Spannung gebracht zu werden,
- einen Transistor (25), welcher Basis-, Emitter- und Kollektor-Anschlüsse aufweist, und
- einen Spannungsteiler (28, 29), der empfindlich ist für die besagte vorgegebene Spannung an dem besagten Verstärkungsregelungs-Eingang (23), wobei der besagte Spannungsteiler einen Abgriffpunkt aufweist, welcher mit dem Basis-Anschluss des besagten Transistors (25) verbunden ist, wobei die besagten Emitter- und Kollektor-Anschlüsse des besagten Transistors (25) mit dem Drain- bzw. dem Gate-Anschluss von mindestens einer der besagten Feldeffekttransistor (FET) -Verstärkerstufen in der besagten Hochfrequenz (HF) -Verstärkerkette (18a, 18b, 18c) verbunden sind.

4. Schaltungsanordnung gemäß einem der vorstehenden Ansprüche, **dadurch gekennzeichnet, dass** die besagte Eingangsstufe (10, 11) mindestens einen Block mit variablem Verstärkungsfaktor (11) sowie eine temperaturempfindliche Reglerschaltungsanordnung (12 bis 15) umfasst, um selektiv den Verstärkungsfaktor des besagten mindestens einen Blocks mit variablem Verstärkungsfaktor (11) in Abhängigkeit von der Temperatur zu verändern.

5. Schaltungsanordnung gemäß einem der vorstehenden Ansprüche, **dadurch gekennzeichnet, dass** die besagte Hochfrequenz (HF) -Verstärkerkette (18a, 18b, 18c) dafür konfiguriert ist, im Zehner-GHz-Bereich, vorzugsweise im 40-GHz-Bereich, zu arbeiten.

**Revendications**

1. Circuit de convertisseur élévateur de fréquence comprenant :

- un étage d'entrée (10, 11) pour produire un signal FI devant être converti à la hausse en fréquence,
- un oscillateur local (17) pour générer un signal d'oscillateur local,
- un étage de mélangeur (16) alimenté avec ledit signal FI et ledit signal d'oscillateur local pour générer un signal RF converti à la hausse en mélangeant ledit signal FI et ledit signal d'oscillateur local
- une chaîne d'amplificateurs RF (18a, 18b, 18c) alimentée avec ledit signal RF converti à la hausse pour amplifier ledit signal RF converti à la hausse d'une valeur de gain donnée,

**caractérisé en ce que** ladite chaîne d'amplificateurs inclut :

a) une pluralité d'étages d'amplificateur (18a, 18b, 18c), dans laquelle chaque étage d'amplificateur de ladite pluralité a une valeur de gain sélectivement commandable respective,
b) au moins un module de commande de gain (180a, 180b, 180c) est prévu pour faire varier ladite valeur de gain donnée de ladite chaîne d'amplificateurs RF en faisant varier uniformément les gains respectifs desdits étages d'amplificateur (18a, 18b, 18c) de ladite chaîne d'amplificateurs RF et

ledit au moins un module de commande de gain (180a, 180b, 180c) a, associé avec celui-ci, un détecteur de puissance RF (20) pour capter la puissance dudit signal RF converti à la hausse tel qu'amplifié de ladite valeur de gain donnée par ladite chaîne d'amplificateurs RF (18a, 18b, 18c), lesdits gains respectifs des étages d'amplificateur (18a, 18b, 18c) de ladite chaîne d'amplificateurs RF étant sélectivement variés en fonction de ladite puissance dudit signal RF converti à la hausse et amplifié.

2. Circuit selon la revendication 1, **caractérisé en ce que** les étages d'amplificateur (18a, 18b, 18c) de ladite chaîne d'amplificateurs RF sont des étages d'amplificateur à FET, lesdits gains respectifs desdits étages d'amplificateur (18a, 18b, 18c) étant variés en faisant varier au moins l'un du courant de drain (Id) et de la tension drain-source (Vds) de l'étage d'amplificateur à FET.

3. Circuit selon la revendication 2, **caractérisé en ce que** ledit au moins un module de commande de gain (180a, 180b, 180c) inclut :

- un port d'entrée de commande de gain (23) adapté pour être mis à une tension de commande de gain donnée,
- un transistor (25) ayant des ports de base, d'émetteur et de collecteur, et
- un diviseur de tension (28, 29) sensible à ladite tension donnée audit port d'entrée de commande de gain (23), ledit diviseur de tension ayant un point de connexion connecté au port de base dudit transistor (25), lesdits ports d'émetteur et de collecteur dudit transistor (25) étant connectés aux ports de drain et de grille, respectivement, d'au moins l'un desdits étages d'amplificateur à FET dans ladite chaîne d'amplificateurs RF (18a, 18b, 18c).

4. Circuit selon l'une quelconque des revendications précédentes, **caractérisé en ce que** ledit étage d'entrée (10, 11) inclut au moins un bloc de gain variable (11) ainsi qu'un circuit de commande sensible à la température (12 à 15) pour faire varier sélectivement le gain dudit au moins un bloc (11) en fonction de la température.

5. Circuit selon l'une quelconque des revendications précédentes, **caractérisé en ce que** ladite chaîne d'amplificateurs RF (18a, 18b, 18c) est configurée de manière à fonctionner dans la plage des dizaines de GHz préférablement dans la plage des 40 GHz.

**Fig. 1**

**Fig. 2**

**Fig. 3**

**Fig. 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20010053676 A
- US 111997 A